# EUROPÄISCHE PATENTANMELDUNG

(11) **EP 4 637 282 A1**
(43) Veröffentlichungstag der Anmeldung: **22.10.2025**
(21) Anmeldenummer: 24170241.4
(22) Anmeldetag: 15.04.2024
(51) Int. Cl.: H05K 7/14

(54) **AUTOMATISIERUNGSBAUGRUPPE MIT EINEM GEHÄUSE**

(71) Anmelder: Siemens Aktiengesellschaft, 80333 München (DE)
(72) Erfinder: Cox, Ned, Johnson City, 37601 (US)
(74) Vertreter: Siemens Patent Attorneys

(57) **Zusammenfassung**

Die Erfindung betrifft eine Automatisierungsbaugruppe (1) mit einem Gehäuse (2), welches eine Rückseite (Ru),
eine Vorderseite (Vo),
eine Unterseite (Un),
eine Oberseite (Ob),
eine linke Seite (li) und
eine rechte Seite (re) aufweist,
in dem Gehäuse (2) ist eine Leiterplatte (LP) zwischen der linken Seite (li) und der rechten Seite (re) des Gehäuses (2) angeordnet,
auf der Leiterplatte (LP) ist in unmittelbarer Nähe zu der Unterseite (Un) ein Steckverbinder-Element (SW1) angeordnet, das Steckverbinder-Element (SW1) ist ausgestaltet ein Steckverbinder-Gegenelement (SM1) aufzunehmen, welches wiederum mit mehreren Anschluss-Klemmen (AK) zur Aufnahme von Signalleitungen versehen ist, wobei in der Vorderseite (Vo) des Gehäuses (2) eine Vertiefung (CP1,CP2) angeordnet ist, wobei die Vertiefung (CP1,CP2) ausgestaltet ist, das Steckverbinder-Gegenelement (SM1) derart aufzunehmen und zu fixieren, dass die Anschluss-Klemmen (AK) nach vorne gerichtet sind, wodurch für eine Fachperson eine Verdrahtungsposition zum Anschließen der Signalleitungen an die Anschluss-Klemmen (AK) realisiert ist.

## Beschreibung

Die Erfindung betrifft eine Automatisierungsbaugruppe mit einem Gehäuse, welches eine Rückseite, eine Vorderseite, eine Unterseite, eine Oberseite, eine linke Seite und eine rechte Seite aufweist, in dem Gehäuse ist eine Leiterplatte zwischen der linken Seite und der rechten Seite des Gehäuses angeordnet, auf der Leiterplatte ist in unmittelbarer Nähe zu der Unterseite ein Steckverbinder-Element angeordnet, das Steckverbinder-Element ist ausgestaltet ein Steckverbinder-Gegenelement aufzunehmen, welches wiederum mit mehreren Anschluss-Klemmen zur Aufnahme von Signalleitungen versehen ist.

Aus den folgenden Patentschriften bzw. Offenlegungsschriften sind Automatisierungskomponenten mit Gehäusen und Anschluss Feldern bzw. mit Steckverbindern für Signalleitungen bereits bekannt. Die EP 2 906 030 B1 beschreibt eine elektronische Baugruppe mit einer elektrisch leitfähigen Verbindung. Die EP 2 624 378 B1 beschreibt eine Ein-/Ausgabebaugruppe der industriellen Automatisierungstechnik. Die EP 2 654 317 B1 zeigt eine Ein-/Ausgabebaugruppe mit einem Anzeigeelement. Die EP 2 683 227 B1 zeigt ein Elektronikmodul zum Einstecken in eine Trägereinheit. Die EP 2 728 984 A1 offenbart ein Gehäuse mit einem ersten Gehäuseteil und mit einem zweiten Gehäuseteil mit einem Zapfengelenk.

Die EP 2 456 017 B1 beschreibt eine Steckervorrichtung für elektronische Baugruppen in Automatisierungssystemen, hier wird eine Steckervorrichtung für die elektronische Baugruppe offenbart, die eine leicht zugängliche Vorverdrahtung von Signalleitungen ermöglicht.

Es ist Aufgabe der Erfindung einer Fachperson die Installation der Verkabelung der Signalleitungen an die Anschluss-Klemmen des Steckverbinder-Gegenelementes zu erleichtern. Es ist derzeit schwierig, den Stecker zu halten, die Federentriegelung am Stecker zu drücken und gleichzeitig das Kabel bzw. die Signalleitung zu installieren bzw. in die Anschluss-Klemme einzuführen.

Die Aufgabe wird dadurch gelöst, dass in der Vorderseite des Gehäuses eine Vertiefung angeordnet ist, wobei die Vertiefung ausgestaltet ist, das Steckverbinder-Gegenelement derart aufzunehmen und zu fixieren, dass die Anschluss-Klemmen nach vorne gerichtet sind, wodurch für eine Fachperson eine Verdrahtungsposition zum Anschließen der Signalleitungen an die Anschluss-Klemmen realisiert ist.

Nun gibt es eine Möglichkeit einer Fachperson eine Verdrahtungsarbeit zu erleichtern. Das Steckverbinder-Gegenelement wird in die Vertiefung gesteckt und dort gehalten. Die Fachperson kann nun die Verbindungen zu den Signalleitungen herstellen.

Sobald die Fachperson die Installation auf dem Gehäuse der Automatisierungsbaugruppe abgeschlossen hat und alle Drähte bzw. Signalleitungen im Steckverbinder-Gegenelement angeschlossen sind, kann nun das verdrahtete Steckverbinder-Gegenelement in das Steckverbinder-Element der Baugruppe gesteckt werden und die Baugruppe kann mit den Prozess-Signalen über die Signalleitungen versorgt werden.

Für eine vorzugsweise Installation der Automatisierungsbaugruppe auf einer Hutschiene oder auf einer Montageplatte, weist das Gehäuse ein Oberteil und ein Unterteil auf, das Unterteil weist die Rückseite und das Oberteil weist die Vorderseite auf, die Rückseite ist ausgestaltet für eine lösbare Montage an einem Baugruppenträger, dabei sind das Oberteil und das Unterteil jeweils mit Verrasthaken bzw. Verrastlöchern zum Ineinanderstecken ausgestaltet.

Um dem Steckverbinder-Gegenelement in dem Gehäuse der Automatisierungsbaugruppe einen festen sicheren Halt zu geben, weist die Vertiefung Zapfen auf, welche derart ausgestaltet sind, dass sie durch ihre Formgebung exakt zwischen Stifte des Steckverbinder-Gegenelements passen.

Um auch unterschiedliche Steckergrößen verwenden zu können, ist die Vertiefung in ein erstes Vertiefungsfeld und ein zweites Vertiefungsfeld aufgeteilt, welche jeweils an einer gemeinsamen Trennwand angeordnet sind. So können beispielsweise auch zwei unterschiedliche Größen von Steck-Verbindern sicher gehalten werden.

Vorzugsweise ist das Oberteil im Bereich der Vertiefung doppelwandig ausgestaltet, dazu verläuft zwischen der linken Seite und der rechten Seite des Oberteils im Bereich der Vertiefung eine erste Ebene und eine zweite Ebene, die zweite Ebene weist die Ausnehmung für die Vertiefung auf und die erste Ebene bildet teilweise den Boden der Vertiefung, dabei verläuft zwischen der ersten Ebene und der zweiten Ebene eine Umrandung, welche senkrecht zur ersten Ebene angeordnet ist und eine seitliche Begrenzungslinie der Vertiefung bildet.

Der doppelwandige Aufbau sorgt für eine zusätzliche Stabilität.

Vorzugsweise ist die Unterseite und die Oberseite zumindest teilweise als ein Lüftungsgitter ausgestaltet, um eine Konvektionskühlung im Inneren des Gehäuses zu ermöglichen.

Um eine Identifizierung der richtigen Anschlussstellen für jede Signalleitung zu erleichtern, ist die Vorderseite des Gehäuses rund um die Vertiefung so ausgestaltet, dass eine Beschriftung als Hinweis für eine Identifizierung der richtigen Position für die Signalleitungen an die Anschluss-Klemmen um die Vertiefung angeordnet ist. Ein Aufkleber könnte eine solche Beschriftung realisieren. Auch wäre eine Laserbeschriftung rund um die Vertiefung denkbar.

Vorzugsweise ist die Vorderseite so ausgestaltet, dass ein Deckel mit einem drehbaren Gelenk angeordnet ist und der Deckel ausgestaltet ist, die Vertiefung abzudecken.

Damit der Deckel nach dem Schließen fest sitz, weist der Deckel auf seiner Innenseite einen Haken auf, welcher ausgestaltet ist, bei geschlossenem Deckel in eine in der Umrandung angebrachten Öffnung einzuschnappen.

In einer weiteren vorteilhaften Ausgestaltung weist der Deckel auf seiner Innenseite ein Stabilisierungselement auf, welches ausgestaltet ist bei geschlossenem Deckel derart in die Vertiefung einzutauchen, dass seitliche Kräfte, welche auf den Deckel wirken, auf das Oberteil übertragen werden. Nun hat man einen Schutz für den Deckel und deren Gelenke oder Scharniere und für den Haken. Eine seitliche Kraft führt nun nicht zu einer Beschädigung des Deckels.

Zusammenfassend kann gesagt werden, dass die Automatisierungsbaugruppe nun über eine "Tasche" oder eine Parkposition, also die Vertiefung, zur Sicherung und Fixierung des Steckverbinder-Gegenelements verfügt, so dass die Fachperson die Verdrahtung mit beiden Händen durchführen kann. Die "Tasche" richtet auch das Steckverbinder-Gegenelement derart aus, dass die Anschluss-Klemmen des Steckverbinder-Gegenelements an den richtigen Stellen der Beschriftung liegen, um die Identifizierung der richtigen Position für jeden Draht zu erleichtern.

Ein Ausführungsbeispiel der Automatisierungsbaugruppe ist in der Zeichnung dargestellt. Es zeigen:
- FIG 1: eine Automatisierungsbaugruppe in einer perspektivischen Darstellung,
- FIG 2: die Automatisierungsbaugruppe mit dem Blick auf eine Vertiefung im Gehäuse,
- FIG 3: die Automatisierungsbaugruppe mit einem eingesteckten SteckverbinderGegenelement in die Vertiefung,
- FIG 4: die Automatisierungsbaugruppe mit einer ersten Vertiefung und einer zweiten Vertiefung im Gehäuse,
- FIG 5: die Vertiefung im Gehäuse im Detail,
- FIG 6: die Automatisierungskomponente mit ausgeblendetem Oberteil und Blick auf die Leiterplatte,
- FIG 7: ein Steckerverbinder-Gegenelement mit Blick auf die Steckkontakte,
- FIG 8: das Steckverbinder-Gegenelement mit Blick auf die Anschlussklemmen,
- FIG 9: das Oberteil des Gehäuses in einer Schnittdarstellung mit Blick auf die Vertiefung,
- FIG 10: die Automatisierungskomponente mit Blick auf die Vertiefung und einem geöffneten Deckel,
- FIG 11: eine Schnittdarstellung mit Blick auf einen Verrastmechanismus des Deckels in der Vertiefung,
- FIG 12: ein Beschriftungsfeld,
- FIG 13: das Beschriftungsfeld mit schematisiertem Steckverbinder-Gegenelement und

- FIG 14: ein Deckel zur Abdeckung der Vertiefung.

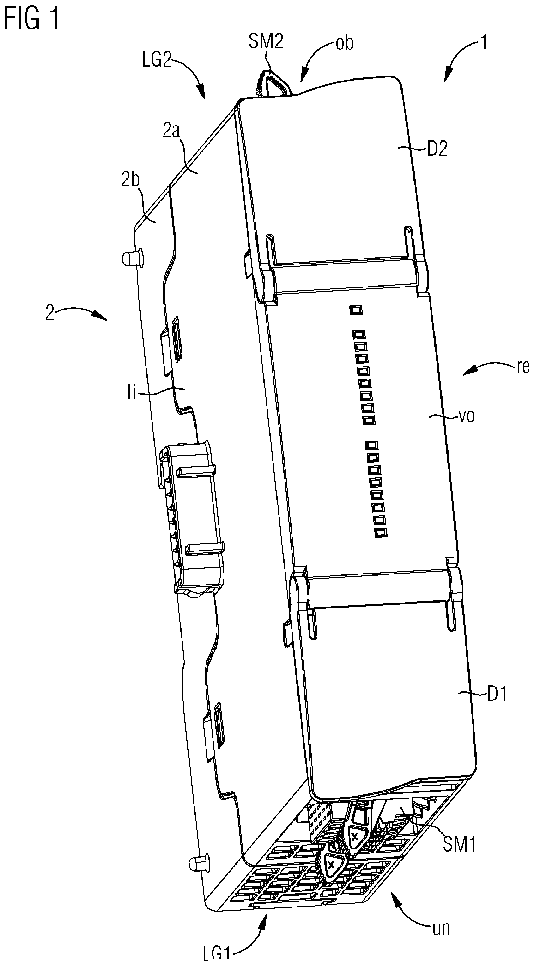

Gemäß FIG 1 ist eine Automatisierungsgruppe 1 mit einem Gehäuse 2 dargestellt, das Gehäuse teilt sich in ein Oberteil 2a und in ein Unterteil 2b auf. Das Oberteil 2a und das Unterteil 2b können zusammengesteckt werden. Weiterhin weist das Gehäuse 2 ein Rückseite Ru, eine Vorderseite Vo, eine Unterseite Un, eine Oberseite Ob, eine linke Seite li und eine rechte Seite re auf.

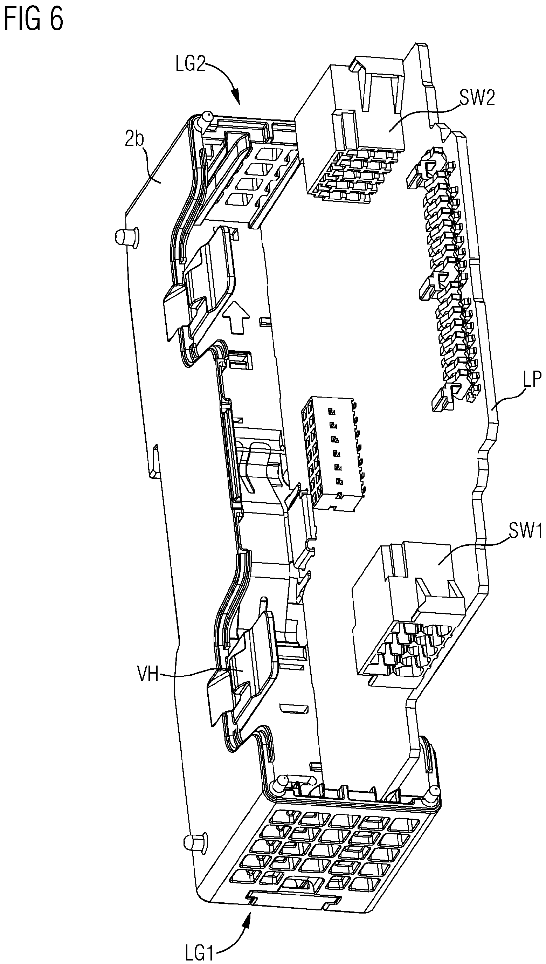

In dem Gehäuse 2 ist eine Leiterplatte LP (siehe FIG 6) angeordnet. Auf der Leiterplatte LP ist in unmittelbarer Nähe zu der Unterseite Un ein Steckverbinder-Element SW1 angeordnet. Ebenso ist auf der Leiterplatte LP in unmittelbarer Nähe zu der Oberseite Ob ein weiteres Steckverbinder-Element SW2 angeordnet. Die Steckverbinder-Elemente SW1 und SW2 sind ausgestaltet, jeweils ein Steckverbinder-Gegenelement SM1,SM2 aufzunehmen. Diese Steckverbinder-Gegenelemente SM1,SM2 weisen wiederum mehrere Anschluss-Klemmen AK zur Aufnahme von Signalleitungen auf. Vorzugsweise ist die dargestellte Automatisierungsgruppe 1 eine Eingabe-/Ausgabe-Baugruppe für industrielle Prozesssignale. Die Signale aus dem Prozess können dann über Signalleitungen an die Steckverbinder-Gegenelement SM1,SM2 herangeführt werden und für eine Kontaktierung in die Anschluss-Klemmen AK gesteckt werden. Auf der Vorderseite Vo in der Mitte der Automatisierungsbaugruppe 1 sind LED-Signalleuchten angeordnet, welche die Zustände der Eingänge bzw. Ausgänge der Signalleitungen anzeigen.

Auf der Vorderseite im Bereich der Unterseite Un ist ein erster Deckel D1 und auf der Vorderseite Vo im Bereich der Oberseite Ob ist ein zweiter Deckel D2 angeordnet. Die Deckel D1,D2 decken jeweils eine Vertiefung CP1,CP2 ab.

An der Unterseite Un ist ein erstes Lüftungsgitter LG1 und an der Oberseite Ob ist ein zweites Lüftungsgitter LG2 angeordnet. Die Lüftungsgitter LG1 und LG2 sorgen dafür, dass durch die Automatisierungsbaugruppe 1 Konvektionsluft geführt werden kann und somit die Automatisierungsbaugruppe 1 von innen gekühlt werden kann.

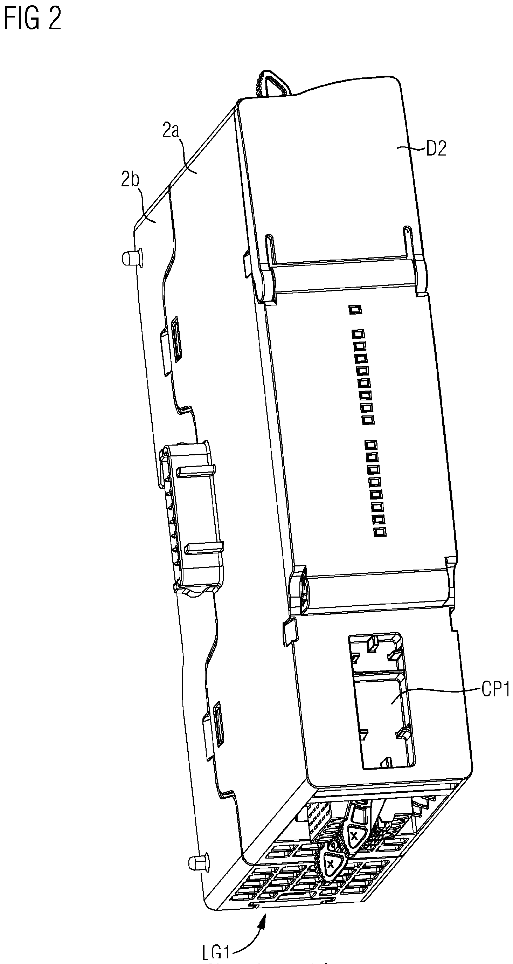

Mit der FIG 2 ist die Automatisierungsbaugruppe 1 aus FIG 1 derart dargestellt, dass an der Unterseite Un der erste Deckel D1 abgenommen ist. Nun wird die Sicht auf eine erste Vertiefung CP1 frei. Die erste Vertiefung CP1 ist in der Vorderseite Vo des Gehäuses 2 bzw. des Oberteils 2a angeordnet. Die erste Vertiefung CP1 ist ausgestaltet, dass erste Steckverbinder-Gegenelement SM1 derart aufzunehmen und zu fixieren, dass die Anschluss-Klemmen AK nach vorne gerichtet sind. Mit einer derartigen Automatisierungsbaugruppe 1 und der entsprechenden ersten Vertiefung CP1 (Connector pocket) hat eine Fachperson nun die Möglichkeit eine Verdrahtungsarbeit des Steckverbinder-Gegenelementes SM1 einfacher auszuführen. Die Fachperson kann das Steckverbinder-Gegenelement SM1 in die erste Vertiefung CP1 stecken, wobei das Steckverbinder-Gegenelement SM1 in der ersten Vertiefung CP1 gehalten wird. Die Fachperson kann nun die Verbindungen zu den Signalleitungen durch Einstecken der Signalleitungen in die Anschluss-Klemmen herstellen.

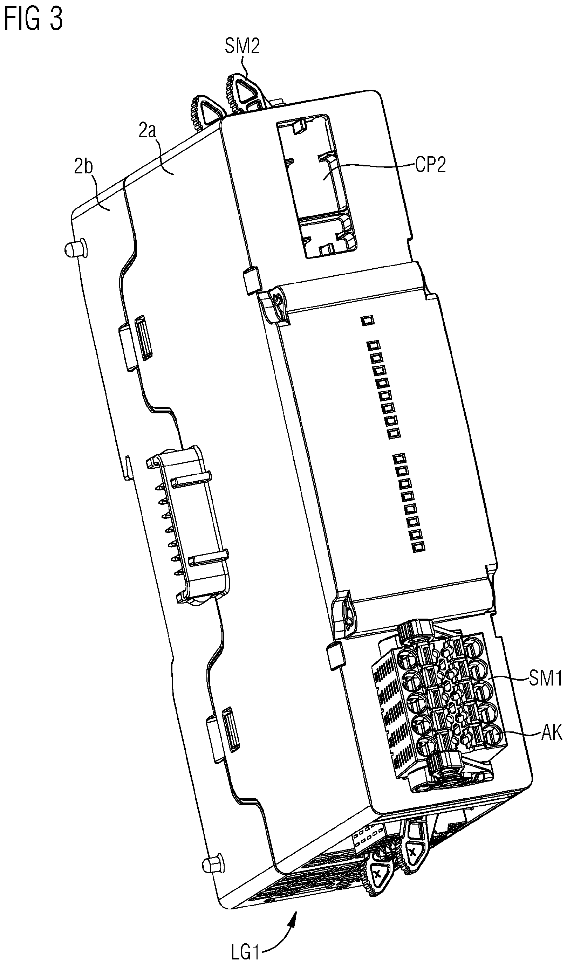

Mit der FIG 3 wird gezeigt, wie das erste Steckverbinder-Gegenelement SM1 in der ersten Vertiefung CP1 steckt. Da diese im Beispiel gezeigte Automatisierungsbaugruppe 1 dafür ausgestaltet ist, von der Oberseite Ob ebenfalls ein Steckverbinder-Gegenelement SM2 aufzunehmen, ist auch an der Vorderseite Vo im Bereich der Oberseite Ob eine zweite Vertiefung CP2 angeordnet.

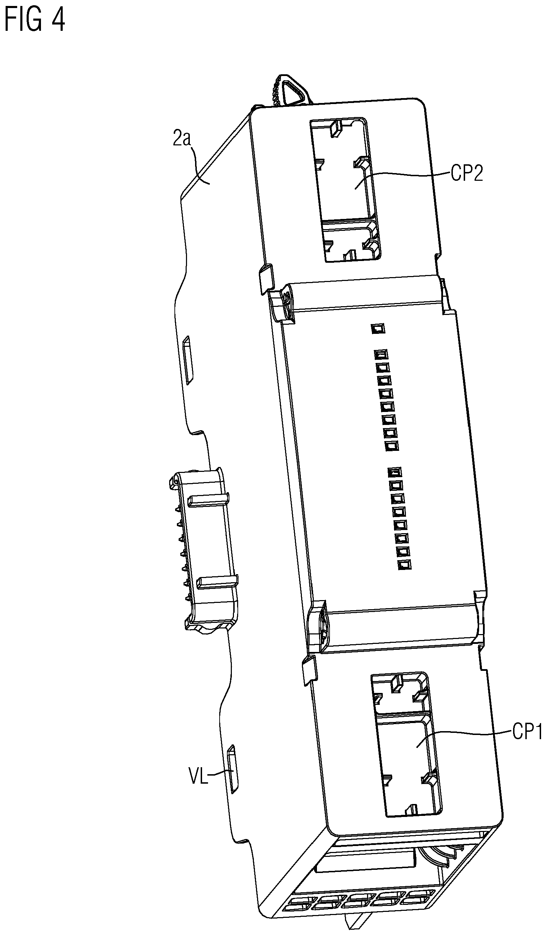

Die FIG 4 verdeutlicht noch einmal die Anordnung der ersten Vertiefung CP1 und der zweiten Vertiefung CP2 im Oberteil 2a des Gehäuses 2.

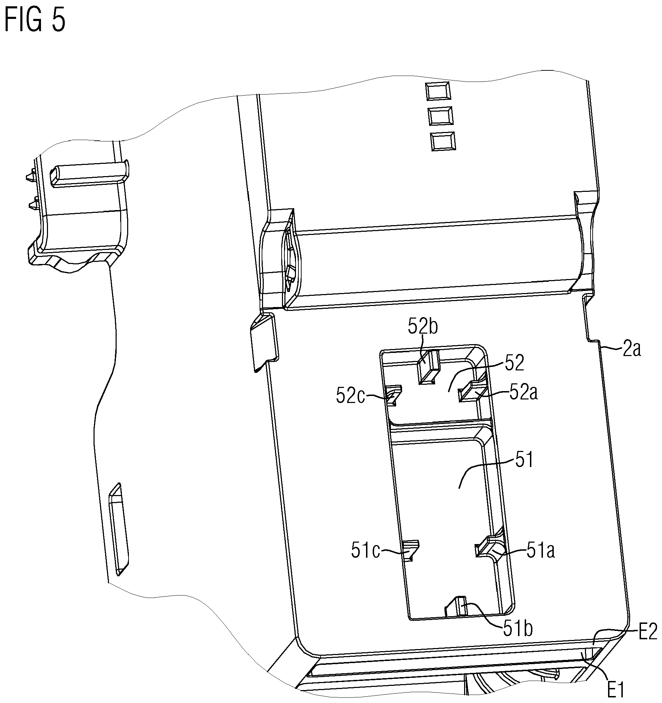

Mit der FIG 5 ist eine Detaildarstellung der ersten Vertiefung CP1 gezeigt. Die erste Vertiefung CP1 weist ein erstes Vertiefungsfeld 51 und ein zweites Vertiefungsfeld 52 auf. Die erste Vertiefung CP1 ist in das erste Vertiefungsfeld 51 und das zweite Vertiefungsfeld 52 aufgeteilt, weil man so zwei unterschiedliche Größen von Steck-Verbindern auch sicher in der ersten Vertiefung CP1 platzieren kann. Das erste Vertiefungsfeld 51 weist einen ersten Zapfen 51a, einen zweiten Zapfen 51b und einen dritten Zapfen 51c auf. Das zweite Vertiefungsfeld 52 weist dementsprechend ebenfalls einen ersten Zapfen 52a, einen zweiten Zapfen 52b und einen dritten Zapfen 52c auf. Das erste Vertiefungsfeld 51 ist von dem zweiten Vertiefungsfeld 52 durch eine Trennwand 53 geteilt. Die entsprechenden Zapfen 51a,51b,51c,52a,52b,52c in den Vertiefungsfeldern 51,52 sind derart ausgestaltet, dass sie durch ihre Formgebung exakt zwischen die Stifte des Steckverbinder-Gegenelements SM1 passen und so dem Steckverbinder-Gegenelement SM1 für eine Verdrahtungsmontage einen sicheren Halt geben.

Gemäß FIG 6 ist die Automatisierungsbaugruppe 1 in einer teilgeöffneten Darstellung dargestellt. Das Oberteil 1b des Gehäuses 2 wurde entfernt und man erhält einen Blick auf die Leiterplatte LP. An der Unterseite Un ist das erste Steckverbinder-Element SW1 angeordnet und auf der Leiterplatte LP an der Oberseite Ob ist das zweite Steckverbinder-Element SW2 angeordnet. Über diese mit der Leiterplatte LP verbundenen Steckverbinder-Elemente SW1,SW2 können über die entsprechenden Steckverbinder-Gegenelemente SM1,SM2 die Signale der Signalleitungen aus dem Prozess an die Automatisierungsbaugruppe 1 herangeführt werden. Der Unterteil 2b des Gehäuses 2 weist Verrasthaken VH auf, welche mit Verrastlöchern VL in dem Oberteil 2a bei zusammengestecktem Oberteil 2a und Unterteil 2b zusammenwirken. In FIG 5 ist ein derartiges Verrastloch VL dargestellt.

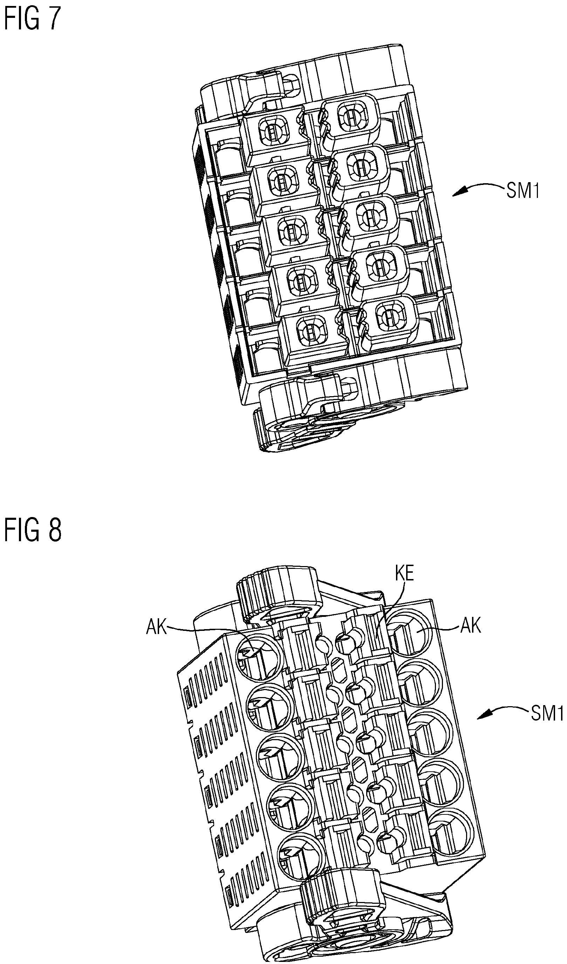

Gemäß FIG 7 ist ein erstes Steckverbinder-Gegenelement SM1 mit Blick auf die Stifte des Steckverbinder-Gegenelementes SM1 dargestellt.

Die FIG 8 zeigt das erste Steckverbinder-Gegenelement SM1 mit Blick auf die Anschluss-Klemmen AK. Mit Hilfe von Klemm-Elementen KE kann in die Anschluss-Klemmen AK ein abisolierter Signalleiter eingefügt werden und kann so einen elektrischen Kontakt zur Anschluss-Klemme AK bis hin zu den Stiften realisieren.

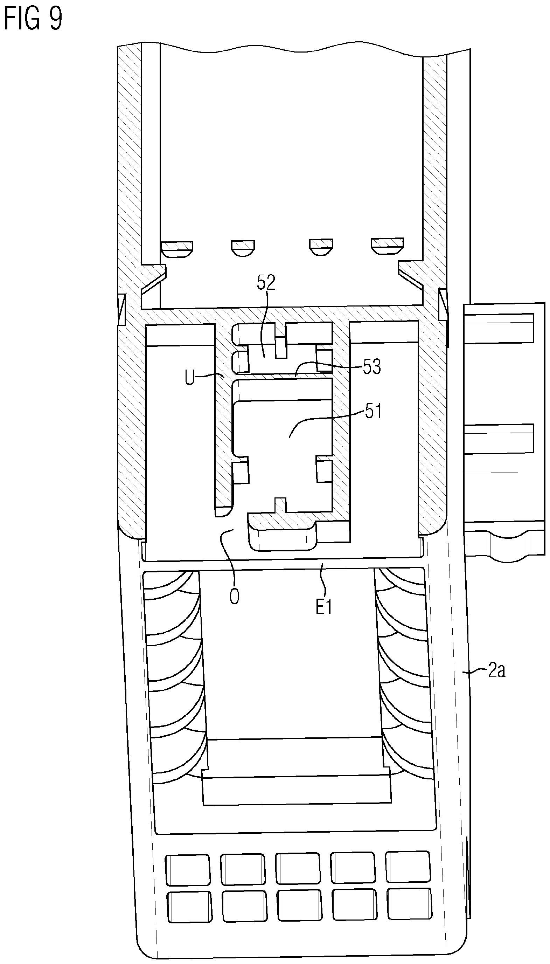

Gemäß FIG 9 ist das Oberteil 2a des Gehäuses 2 in einer Schnittdarstellung dargestellt.

FIG 9 lässt damit einen Blick auf eine erste Ebene E1 zu und zeigt eine Umrandung U der ersten Vertiefung CP1. In der FIG 5 wurde gezeigt, dass das Oberteil 2a im Bereich der Vertiefung CP1,CP2 doppelwandig ausgestaltet ist. Dazu verläuft zwischen der linken Seite li und der rechten Seite re des Oberteils 2a im Bereich der Vertiefung CP1 ,CP2 eine erste Ebene E1 und eine zweite Ebene E2. Die zweite Ebene E2 weist die Ausnehmung für die Vertiefung CP1,CP2 auf. Die erste Ebene E1 bildet teilweise den Boden der Vertiefung CP1,CP2. Dabei verläuft zwischen der ersten Ebene E1 und der zweiten Ebene E2 die Umrandung U, welche senkrecht zur ersten Ebene E1 angeordnet ist und eine seitliche Begrenzungslinie der Vertiefung CP1,CP2 bildet. Der doppelwandige Aufbau sorgt für eine zusätzliche Stabilität.

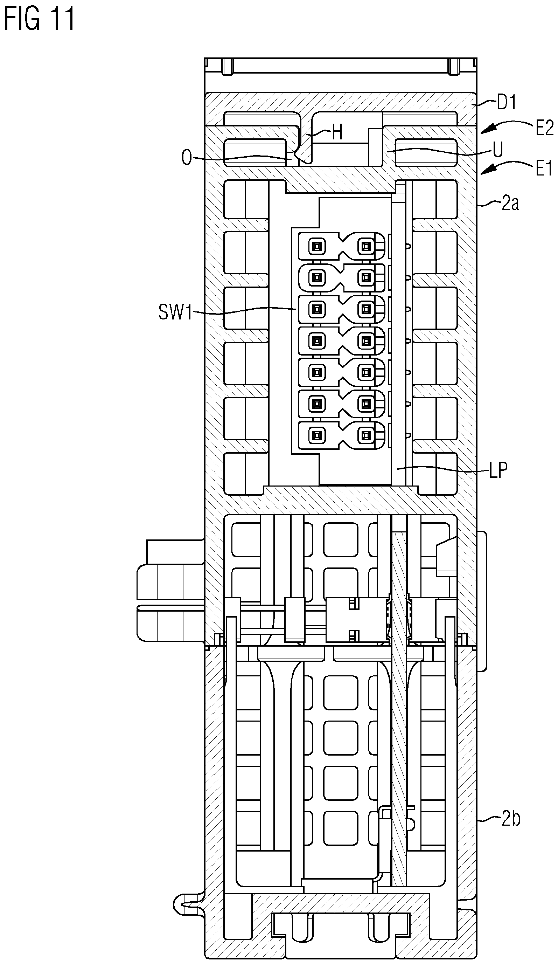

Wie die FIG 9 weiter zeigt, ist in der Umrandung U eine Öffnung O angebracht. Diese Öffnung O dient dazu, dass der Deckel D1,D2 sicher geschlossen werden kann. Dazu ist auf der Innenseite des Deckels D1,D2 ein Haken H angeordnet, welcher ausgestaltet ist, bei geschlossenem Deckel D1,D2 in die in der Umrandung U angebrachten Öffnung O einzuschnappen (siehe hierzu auch FIG 11). FIG 11 ist in einer Schnittdarstellung mit Sicht auf die Unterseite Un dargestellt. Der erste Deckel D1 ist im geschlossenen Zustand dargestellt und dementsprechend ist der Haken H von dem ersten Deckel D1 in der Öffnung O der Umrandung U verrastet.

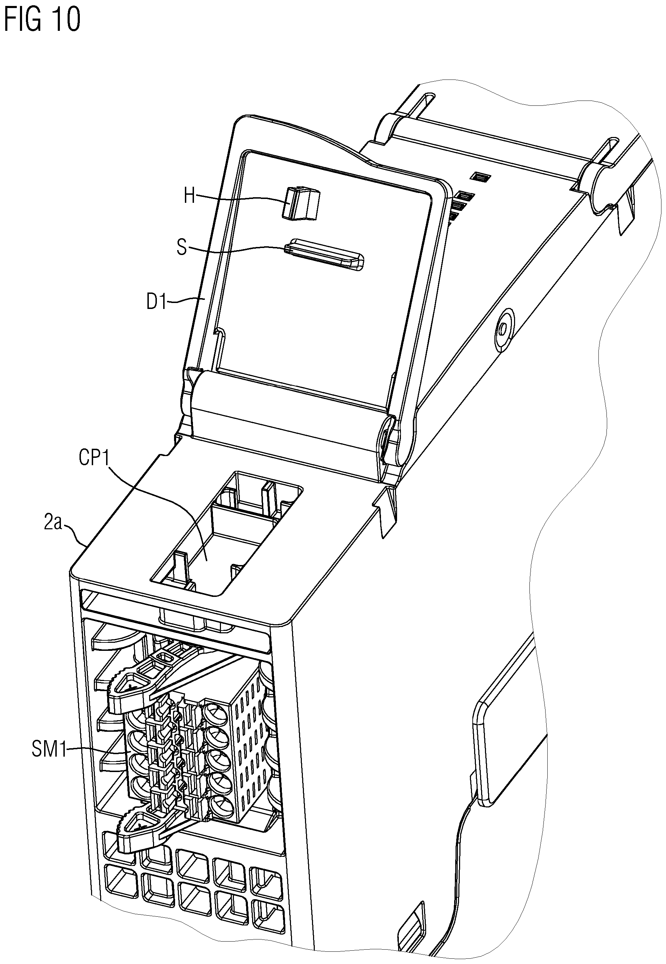

Zur weiteren Veranschaulichung zeigt FIG 10 in einer perspektivischen Darstellung den geöffneten ersten Deckel D1 mit Blick auf die erste Vertiefung CP1 und eingestecktem Steckverbinder-Gegenelement SM1 in das entsprechende erste Steckverbinder-Element SW1. Damit der erste Deckel D1 nach dem Schließen festsitzt, weist der erste Deckel D1 auf seiner Innenseite nicht nur den Haken H auf, sondern auch ein Stabilisierungselement S auf. Das Stabilisierungselement S ist derart ausgestaltet, dass bei geschlossenem ersten Deckel D1 das Stabilisierungselement S in die erste Vertiefung CP1 passgenau eintauchen kann. Sollten nun seitliche Kräfte auf den ersten Deckel D1 wirken, werden diese seitlichen Kräfte auf das Oberteil 2a übertragen. Der erste Deckel D1 ist nun vor seitlichen Kräften geschützt, welche ansonsten die Gelenke oder das Scharnier und/oder den Haken H des ersten Deckels D1 zerstören könnten. Eine seitliche Kraft führt nun nicht mehr zu einer Beschädigung des ersten Deckels D1.

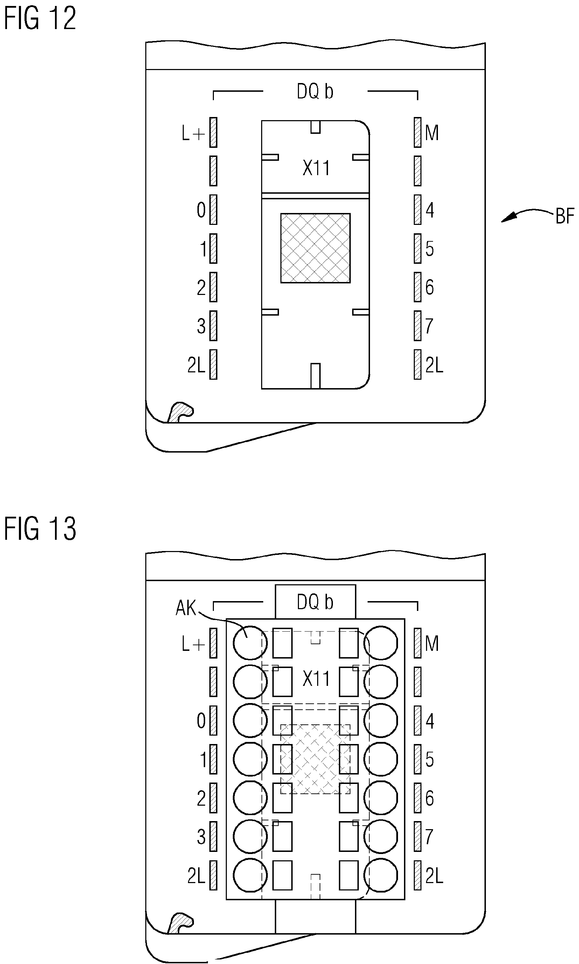

Gemäß FIG 12 ist ein Beschriftungsfeld BF dargestellt. Das Beschriftungsfeld BF kann beispielsweise als ein Aufkleber ausgestaltet sein. Weiterhin ist das Beschriftungsfeld BF derart ausgestaltet, dass es genau um die erste Vertiefung CP1 angeordnet werden kann. Steckt nun ein Steckverbinder-Gegenelement SM1 in der ersten Vertiefung CP1 so kann die Fachperson ablesen an welcher Anschlussklemme AK sie welche Signalleitungen anschließen muss. Im Beispiel ist ein Anschlussplan für eine Relaisbaugruppe dargestellt. Die Relaisbaugruppe wird mit ihren Ausgängen in der der Abkürzung DQB dargestellt. Auf der linken Seite der Anschluss-Klemmen AK wird von oben eine Spannungsversorgung L+ und auf der rechten Seite der Anschluss-Klemmen AK wird eine Masseversorgung M angeschlossen. Die weiteren Klemmen links sowie rechts sind durchnummeriert von Null bis Sieben. Das bedeutet, entsprechend können acht Ausgänge angesteuert werden. Die Anschluss-Klemmen 2L sind für Sonderzwecke vorbehalten.

Gemäß FIG 13 ist das aus FIG 12 gezeigte Beschriftungsfeld BF noch einmal dargestellt, mit der Besonderheit, dass schematisiert das Steckverbinder-Gegenelement SM1 dargestellt ist und so noch einmal der direkte Bezug zwischen Anschluss-Klemmen AK und Beschriftungshinweisen des Beschriftungsfeldes BF gegeben ist.

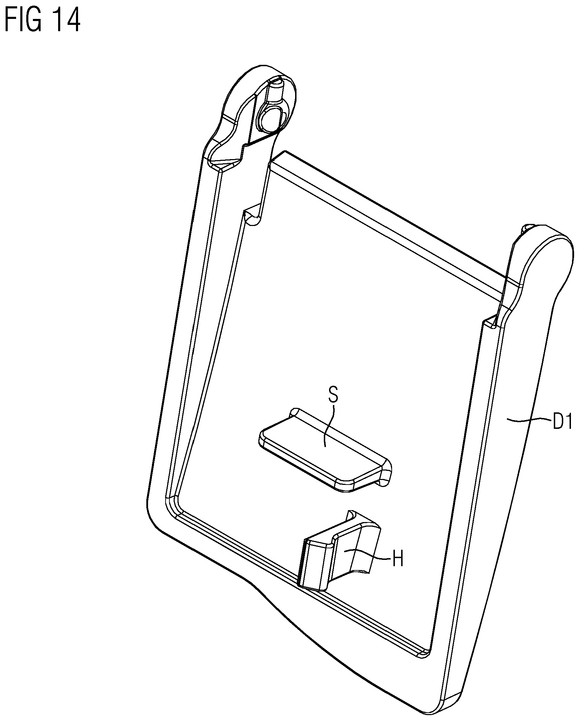

Mit der FIG 14 ist der erste Deckel D1 noch einmal in einer Detaildarstellung dargestellt. Der erste Deckel D1 weist für ein sicheres Verschließen in der ersten Vertiefung CP1 einen Haken H auf und für eine Aufnahme von später wirkenden seitlichen Kräften auf den ersten Deckel D1 weist der erste Deckel D1 weiterhin ein Stabilisierungselement S auf. Das Stabilisierungselement S ist vorzugsweise in seiner Breite genauso breit ausgestaltet, dass es genau in die erste Vertiefung CP1 ohne seitliches Spiel eintauchen kann.

## Patentansprüche

1. Automatisierungsbaugruppe (1) mit einem Gehäuse (2), welches eine Rückseite (Ru),
eine Vorderseite (Vo),
eine Unterseite (Un),
eine Oberseite (Ob),
eine linke Seite (li) und
eine rechte Seite (re) aufweist,
in dem Gehäuse (2) ist eine Leiterplatte (LP) zwischen der linken Seite (li) und der rechten Seite (re) des Gehäuses (2) angeordnet,
auf der Leiterplatte (LP) ist in unmittelbarer Nähe zu der Unterseite (Un) ein Steckverbinder-Element (SW1) angeordnet, das Steckverbinder-Element (SW1) ist ausgestaltet ein Steckverbinder-Gegenelement (SM1) aufzunehmen, welches wiederum mit mehreren Anschluss-Klemmen (AK) zur Aufnahme von Signalleitungen versehen ist,
**dadurch gekennzeichnet, dass** in der Vorderseite (Vo) des Gehäuses (2) eine Vertiefung (CP1,CP2) angeordnet ist, wobei die Vertiefung (CP1,CP2) ausgestaltet ist, das Steckverbinder-Gegenelement (SM1) derart aufzunehmen und zu fixieren, dass die Anschluss-Klemmen (AK) nach vorne gerichtet sind, wodurch eine Verdrahtungsposition zum Anschließen der Signalleitungen an die Anschluss-Klemmen (AK) realisiert ist.

2. Automatisierungsbaugruppe (1) nach Anspruch 1, wobei das Gehäuse (2) ein Oberteil (2a) und ein Unterteil (2b) umfasst, das Unterteil (2b) weist die Rückseite (Ru) und das Oberteil (2a) weist die Vorderseite (Vo) auf, die Rückseite (Ru) ist ausgestaltet für eine lösbare Montage an einem Baugruppenträger, dabei sind das Oberteil (2a) und das Unterteil (2b) jeweils mit Verrasthaken (VH) bzw. Verrastlöchern (VL) zum Ineinanderstecken ausgestaltet.

3. Automatisierungsbaugruppe (1) nach Anspruch 1 oder 2, wobei die Vertiefung (CP1,CP2) Zapfen (51a,51b,51c) aufweist, welche derart ausgestaltet sind, dass sie die durch ihre Formgebung exakt zwischen Stifte des Steckverbinder-Gegenelements (SM1) passen.

4. Automatisierungsbaugruppe (1) nach einem der Ansprüche 1 bis 3, wobei die Vertiefung (CP1,CP2) in ein erstes Vertiefungsfeld (51) und ein zweites Vertiefungsfeld (52) aufgeteilt ist, welche jeweils an einer gemeinsamen Trennwand (53) angeordnet sind.

5. Automatisierungsbaugruppe (1) nach einem der Ansprüche 1 bis 4, wobei das Oberteil (2a) im Bereich der Vertiefung (CP1,CP2) doppelwandig ausgestaltet ist, dazu verläuft zwischen der linken Seite (li) und der rechten Seite (re) des Oberteils (2a) im Bereich der Vertiefung (CP1,CP2) eine erste Ebene (E1) und eine zweite Ebene (E2), die zweite Ebene (E2) weist die Ausnehmung für die Vertiefung (CP1,CP2) auf und die erste Ebene (E1) bildet teilweise den Boden der Vertiefung (CP1,CP2), zwischen der ersten Ebene (E1) und der zweiten Ebene (E2) verläuft eine Umrandung (U), welche senkrecht zur ersten Ebene (E1) angeordnet ist.

6. Automatisierungsbaugruppe (1) nach einem der Ansprüche 1 bis 5, wobei die Unterseite (Un) und die Oberseite (Ob) zumindest teilweise als ein Lüftungsgitter (LG1,LG2) ausgestaltet sind, um eine Konvektionskühlung im Inneren des Gehäuses (2) zu ermöglichen.

7. Automatisierungsbaugruppe (1) nach einem der Ansprüche 1 bis 6, wobei die Vorderseite (Vo) des Gehäuses (2) rund um die Vertiefung (CP1,CP2) so ausgestaltet ist, dass eine Beschriftung als Hinweis für eine Identifizierung der richtigen Position für die Signalleitungen an die Anschluss-Klemmen (AK) um die Vertiefung (CP1,CP2) angeordnet ist.

8. Automatisierungsbaugruppe (1) nach einem der Ansprüche 1 bis 7, wobei die Vorderseite (Vo) so ausgestaltet ist, dass ein Deckel (D1,D2) mit einem drehbaren Gelenk angeordnet ist und der Deckel (D1,D2) ausgestaltet ist die Vertiefung (CP1,CP2) abzudecken.

9. Automatisierungsbaugruppe (1) nach Anspruch 8, wobei der Deckel (D1,D2) auf seiner Innenseite einen Haken (H) aufweist, welcher ausgestaltet ist bei geschlossenem Deckel (D1,D2) in eine in der Umrandung (U) angebrachten Öffnung (O) einzuschnappen.

10. Automatisierungsbaugruppe (1) nach Anspruch 8 oder 9, wobei der Deckel (D1,D2) auf seiner Innenseite ein Stabilisierungselement (S) aufweist, welches ausgestaltet ist bei geschlossenem Deckel (D1,D2) derart in die Vertiefung einzutauchen, dass seitliche Kräfte welche auf den Deckel (D1,D2) wirken auf das Oberteil übertragen werden.
